# EUROPEAN PATENT SPECIFICATION

(11) **EP 1 537 584 B1**
(45) Date of publication and mention of the grant of the patent: **25.10.2017**
(21) Application number: 02761617.6
(22) Date of filing: 11.09.2002
(51) Int. Cl.: G11C 11/34

(54) **PROGRAMMING A PHASE-CHANGE MATERIAL MEMORY**
PROGRAMMIERUNG EINES PHASENWECHSELMATERIALSPEICHER
PROGRAMMATION DE LA MEMOIRE D'UN MATERIAU A CHANGEMENT DE PHASE

(43) Date of publication of application: 08.06.2005
(73) Proprietor: Ovonyx Memory Technology, LLC, Alexandria, VA 22314 (US)
(72) Inventor: LOWREY, Tyler, A., West Augusta, VA 24485 (US)
(74) Representative: Samson & Partner Patentanwälte mbB
(86) International application number: PCT/US2002/028811
(87) International publication number: WO 2004/025659

(56) References cited:
- GB-A- 1 372 414

## Description

### Background

This invention is related to techniques for programming a structural phase-change material solid state memory device such as those that use a chalcogenide material which can be programmed into different resistivity states to store data.

Solid state memory devices that use a structural phase-change material as the data storage mechanism (referred to here simply as 'phase-change memories') offer significant advantages in both cost and performance over conventional charge storage based memories. The phase-change memory is made of an array of constituent cells where each cell has some structural phase-change material to store the cell's data. This material may be, for instance, a chalcogenide alloy that exhibits a reversible structural phase change from amorphous to crystalline. A small volume of the chalcogenide alloy is integrated into a circuit that allows the cell to act as a fast switching programmable resistor. This programmable resistor can exhibit greater than 40 times dynamic range of resistivity between the crystalline state (low resistivity) and the amorphous state (high resistivity), and is also capable of exhibiting multiple, intermediate states that allow multi-bit storage in each cell. The data stored in the cell is read by measuring the cell's resistance. The chalcogenide alloy cell is also non-volatile.

A conventional technique for programming a phase-change memory cell is to apply a rectangular pulse of current (having a constant magnitude) to the cell, at a voltage greater than a switching threshold for the phase-change material, which leaves the material in the reset state (amorphous and high resistivity). This may be followed by the application of a subsequent rectangular pulse, also at a voltage greater than the switching threshold, which changes the material to a set state (crystalline and low resistivity). The reset pulse has a higher magnitude of current than the set pulse so that the temperature of the phase change material is raised to Tₘ, the amorphizing temperature, before the material is rapidly cooled down and is left in the amorphous state. To change into the crystalline state, the material can be heated back up to an optimum temperature Tₒₚₜ, which is lower than Tₘ. The temperature Tₒₚₜ is that which allows the material in the cell to be crystallized in a relatively short time interval and yielding a relatively low resistance. Ideally, this could be accomplished by having the magnitude of the set pulse be smaller than that of the reset pulse to prevent the phase-change material from reaching the amorphizing temperature, but large enough to cause the material to reach Tₒₚₜ.

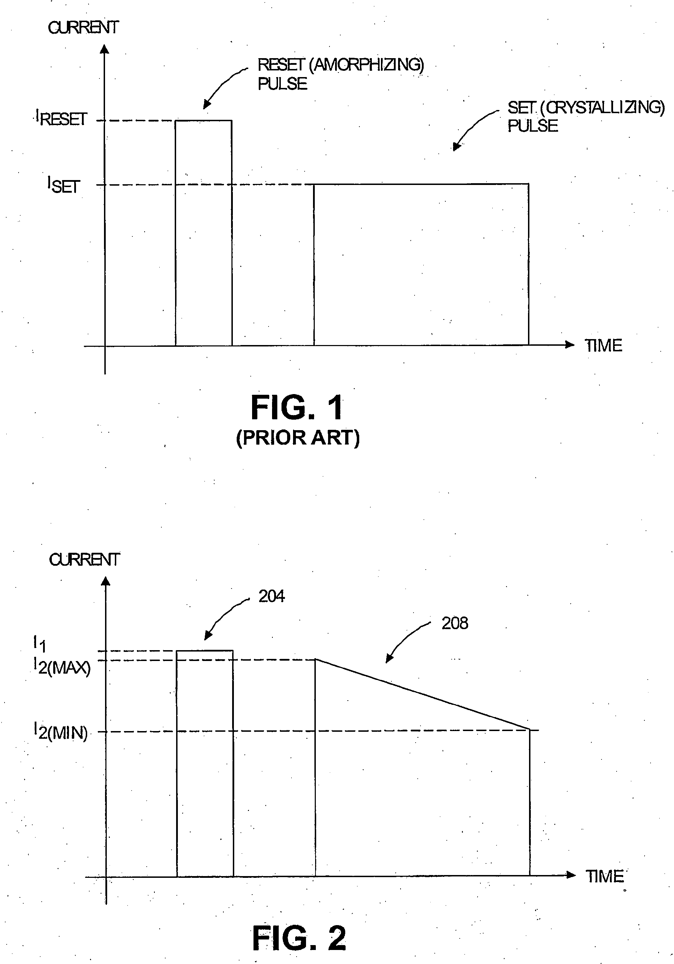

Because of fabrication process and material variations in phase change memories, the actual temperature of the phase-change material in the cells of a manufactured device varies significantly from cell to cell, for a given programming current/voltage level obtained by a set pulse. This variation can cause the material in one or more cells of a device to inadvertently reach Tₘ during application of the conventional rectangular set pulse, and thereby cause those cells to erroneously remain in the reset state rather than change to the set state. To avoid this problem, conventional programming techniques use a rectangular set pulse (applied to every cell in the device) that has a reduced magnitude, as shown in Fig. 1. The magnitude of the set current is sufficiently low, in view of the expected variation in cell temperature at that magnitude, to guarantee that no cell in the device reaches Tm while the set pulse is applied to it. This solution, however, may slow down the programming of the memory device, since a longer rectangular set pulse is needed due to the less than optimal temperatures being generated by the lower magnitude of the set pulse. In addition, many cells in the memory are subjected to significantly less than the optimum crystallization temperature which reduces the dynamic range in resistivity between the set and reset states in those cells.

US-A-3,980,505 discloses a memory device including a pair of spaced electrodes between which extends a body of a generally amorphous high resistance memory semiconductor material made of a composition of at least two elements. Application to the electrodes of a set voltage pulse produces a relatively low resistance filamentous path comprising a deposit of at least one of said elements in a crystalline or relatively disordered state.

US-A-3,922,648 proposes to apply a current pulse to set a phase-change memory cell and a plurality of current pulses to reset the memory cell.

According to a method described in GB-A-1 372 414, voltage pulses of fixed magnitude and duration are applied for setting the states of a memory cell comprising phase-change material.

US-A-3,448,302 describes an operating circuit for controlling and correcting for the deviation in a turn-on voltage of a phase change memory device having two stable states. The circuit applies a control signal to sense the level of the turn-on voltage of the device. Then, the circuit responds to the sensed condition by delivering a required number of turn-off current pulses to the device to cause the turn-on voltage to fall within an acceptable range of values.

US 6,075,719 discloses a method of programming phase-change memory elements, wherein pulses can be characterized by an amplitude, duration, rise time and fall time and used to switch states of the memory bits.

WO 03/058633 discloses a method and apparatus to program a phase change memory. In particular, it discloses to adjust a fall time of a non-rectangular pulse in order to increase reliability of write processes in a solid-state memory device. The disclosed phase change memory device comprises a programming signal generator device, a read device and a timing device.

### Summary of the Invention

According to an aspect, the present invention provides a method for programming a memory device, according to the subject-matter of claim 1. According to another aspect, the present invention provides a memory device according to the subject-matter of claim 4. Preferred embodiments of the invention are set forth in the dependent claims, the following description and the drawings.

### Brief Description Of The Drawings

The invention is illustrated by way of example and not by way of limitation in the figures of the accompanying drawings in which like references indicate similar elements. It should be noted that references to "an" embodiment in this disclosure are not necessarily to the same embodiment, and they mean at least one.
Fig. 1 shows a conventional sequence of pulses for programming a phase-change memory.
Fig. 2 illustrates a sequence of phase-change memory programming pulses including a set sweep, according to an embodiment of the invention.
Fig. 3 illustrates a plot of crystallization time in a phase-change material memory cell as a function of the temperature of the phase-change material.
Fig. 4 depicts another sequence of phase-change memory programming pulses, including a set sweep.
Fig. 5 shows the variation in the temperature of phase-change material in a memory cell versus time, while a set sweep according to an embodiment of the invention is being applied to the cell.
Fig. 6 illustrates a plot of memory cell resistance versus programming current level, for a particular phase-change memory device.
Fig. 7 depicts a plot of memory cell resistance versus programming current for a large population of memory cells, showing an example of a relatively wide variation in the population.
Fig. 8 illustrates a block diagram of a phase-change material memory device, including waveshaping and driving circuitry that are designed to provide the voltage and current levels needed to program the constituent cells of the device.
Fig. 9 depicts a block diagram of an embodiment of a portable application of a phase-change memory that incorporates the programming process.

### Detailed Description

According to the invention, the set pulse for programming a phase-change memory is shaped to be generally triangular, rather than rectangular. Such a pulse is also referred to here as a 'set sweep'. With the set sweep, the magnitude of the set pulse current can be increased, so that the phase-change material in all cells of a device can reach temperatures of at least Tₒₚₜ during the set pulse yet still change to the set state, due to the downward slope in the trailing portion of the pulse. Better crystallization takes place in the memory, despite fabrication process and material variations. With better crystallization, the resistivity differences between the set and reset states are more pronounced. This means that the tolerance for variations in the memory has increased, therefore lowering manufacturing costs by allowing greater yields from the fabrication and testing flows.

Although the memory device may reach temperatures as high as Tₘ when the magnitude of the triangular set pulse is greater than the conventional set current magnitude, the triangular shaped pulse has a decaying or downward sloping trailing portion such that even those cells that reach Tₘ will have a chance to cool down to and crystallize at or near Tₒₚₜ. The decay during the trailing portion is slow enough to ensure that those cells spend the minimum required time interval at approximately Tₒₚₜ, to yield better crystallization even in those cells. For devices that are expected to have large variations across their cell populations, the time of the current transition from its maximum value to its minimum value for the slope of the trailing portion may need to be longer than for devices that are expected to show relatively small variations.

Fig. 2 illustrates a sequence of phase-change memory programming pulses, according to an embodiment of the invention. A first pulse 204 is applied to a constituent cell of a phase-change memory. This pulse may be of any conventional type. A typical shape is rectangular as shown, with a constant, current magnitude. Rectangular pulses are relatively easy to generate, using only a single switching transistor (not shown). The first pulse 204 may, as mentioned above in the background, be a reset or amorphizing pulse having a magnitude Iᵣₑₛₑₜ that is sufficiently high such that the phase-change material in the cell reaches Tₘ, the amorphizing temperature of the material. Alternatively, the current magnitude may be different so long as the first pulse 204 leaves the cell in a predefined state. The pulse width of the first pulse 204 is also selected to be long enough to achieve the predefined state.

Application of the first pulse 204 is followed by a second pulse 208 which is generally triangular in shape, as shown. The second pulse 208 has a leading portion that peaks at the magnitude or maximum, I₂₍ₘₐₓ₎, and a trailing portion that decays to a minimum value I₂₍ₘᵢₙ₎. The leading portion may have a much greater slope than the trailing portion. The shape of the second pulse 208 can be selected, in view of fabrication process and material variations across the phase-change materials and the circuitry in the constituent cells of the memory device, such that every cell of the memory device changes from the first state to a second, different state if the second pulse 208 were applied to each of them. The first and second states may be the reset and set states mentioned above in the background. The shaping of the second pulse 208 involves setting a number of parameters that include the maximum and minimum values, and the decay rate/pulse width, in view of the structure and type of phase-change material used, as well as the operating thermal environment of the memory device.

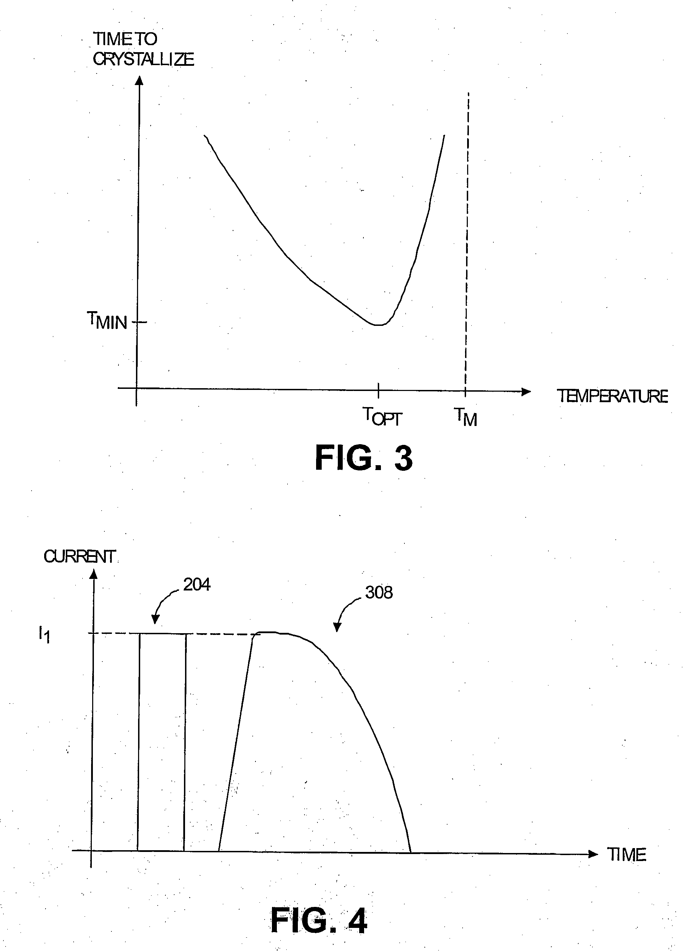

The levels of I₂₍ₘₐₓ₎ and I₂₍ₘᵢₙ₎ may assume a wide range of values. For instance, I₂₍ₘₐₓ₎ may be substantially greater than Iᵣₑₛₑₜ. Crystallization is a function of both the temperature and the amount of time the material spends at that temperature. This may be explained by Fig. 3 which illustrates an exemplary plot of crystallization time (in a phase-change material
memory cell) as a function of the temperature of the phase-change material. The plot shows that at temperatures below Tₒₚₜ, the material needs a longer time interval to crystallize. Hence, at lower current magnitudes (which translates roughly to lower temperatures being generated in the phase-change material), longer pulse widths are needed to set the phase-change memory cell. Ideally, a set pulse should have a current magnitude that yields Tₒₚₜ, for as many cells as possible in a memory device, so as to provide the shortest set programming interval, Tₘᵢₙ, as well the lowest set state resistance for those cells.

The level of I₂₍ₘᵢₙ₎ may also vary over a wide range of values, including as low as zero. Ideally, an upper bound on I₂₍ₘᵢₙ₎ for a set pulse may be one which insures that the temperature of the phase-change material in all cells to which the pulse will be applied is below Tₘ at the end of the pulse (when I₂₍ₘₘ₎ has been reached).

Fig. 4 depicts another sequence of phase-change memory programming pulses. Note how the second pulse (set sweep) 308 in this example, although still referred to as generally triangular, has a relatively short intermediate portion between the leading and trailing portions, wherein the intermediate portion has essentially zero slope relative to the leading and trailing portions. Also, in contrast to the linear decay rate of Fig. 2, the trailing portion in Fig. 4 has a nonlinear slope. In general, the decay rate in the trailing portion may be of a wide range, including polynomial, logarithmic, and exponential, so long as the trailing portions cause all relevant cells in the device to sweep through a rapid crystallization temperature interval.

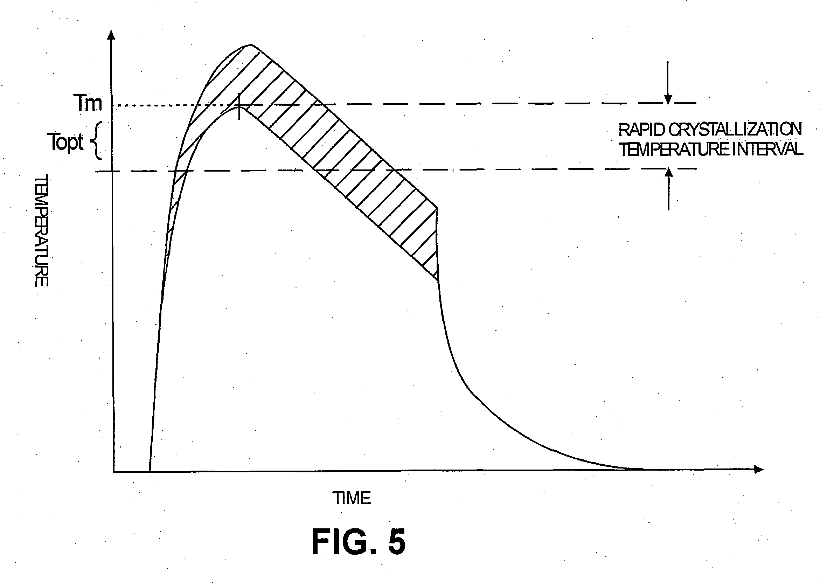

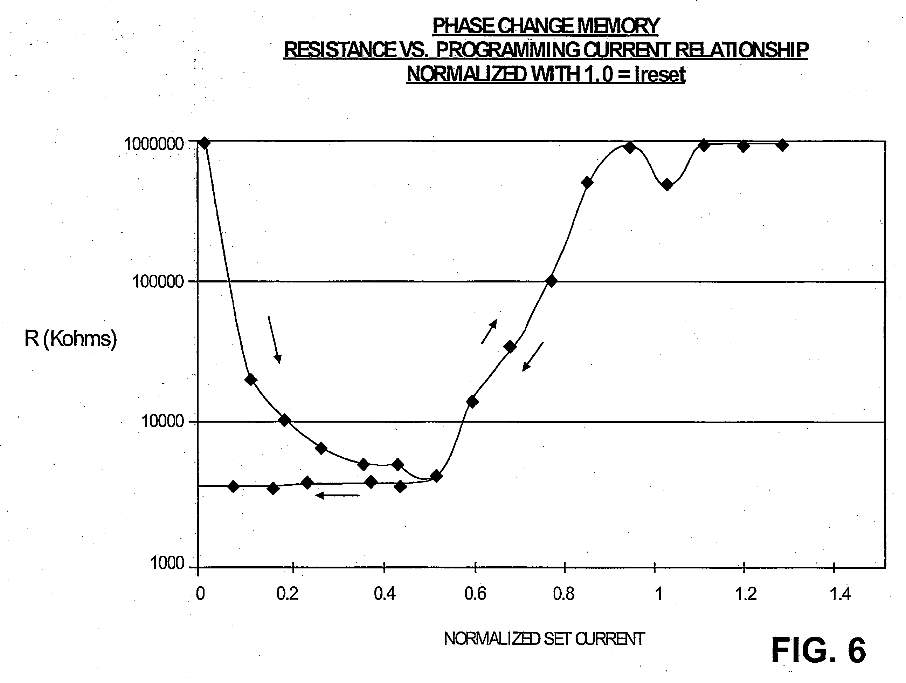

The effect of the triangular set pulse on cell temperatures in a phase-change memory are illustrated in the exemplary plot of Fig. 5. It can be seen that even with large variation in temperature (depicted by the shaded band) for a given magnitude and decay rate in the triangular set pulse, the entire memory device is swept through a rapid crystallization temperature interval, so that optimum, i.e. lowest, set resistance is obtained for all cells in the device. This is also illustrated in Fig. 6 which is a plot of memory cell resistance versus set current for a particular phase-change memory device. The resistance is plotted as the memory cell, beginning in the reset state, responds to the various levels of programming current. The sequence for applying the various levels of programming current is indicated by the arrows, starting from the left and then moving to the right and then coming back to the left. As can be seen, the lowest set resistance may be obtained at a value of set current just prior to its rapid rise towards the reset level. Advantageously, the triangular nature of the set pulse allows this lowest set resistance to be 'locked in' as the set sweep pulse sweeps back down from its peak value. Assuring the lowest set resistance for each cell in the memory device provides superior margin for memory read operations, higher manufacturing yields, as well as better product reliability.

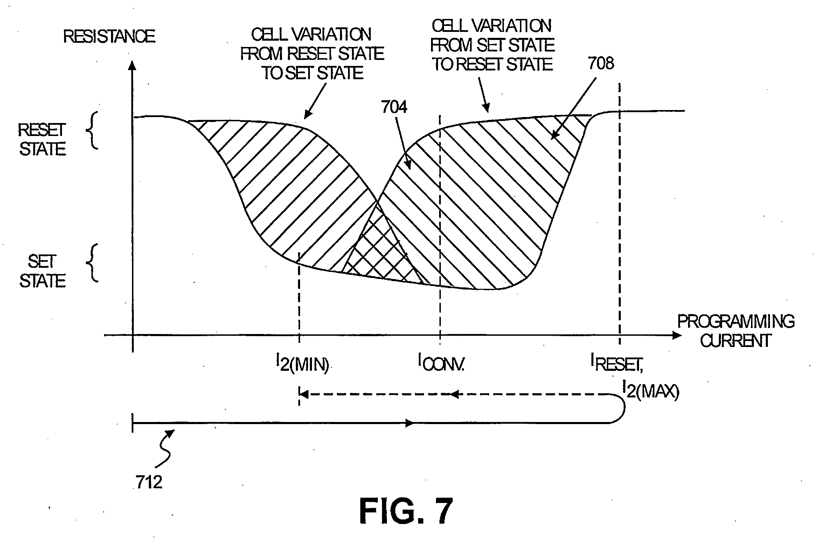

The advantages of the set sweep can also be appreciated by considering Fig. 7 which depicts a plot of memory cell resistance versus programming current for a large population of memory cells in a memory device. This device suffers from a relatively wide variation in the population of its constituent memory cells. To take all of the cells from the set state to the reset state, the application (to each cell) of the conventional rectangular pulse of magnitude Iᵣₑₛₑₜ will work. However, the conventional programming technique of applying the same rectangular set pulse (with a constant magnitude) would be unable to return every cell in the device to the set state. That's because to do so the current magnitude needs to be at least as high as I_{conv}. But at that magnitude some of the cells, namely those falling within region 704, will stay at the reset state when the pulse has abruptly ended. In contrast, this does not occur with the set sweep if I₂₍ₘᵢₙ₎ is selected to be as shown, since all cells, including those in region 704 as well as those in region 708, will be swept through their crystallization temperature intervals (and therefore assured of returning to the set state) by the time the pulse has slowly decayed to I₂₍ₘᵢₙ₎. The set sweep is indicated by a loop 712 whose trailing portion is shown in dotted lines.

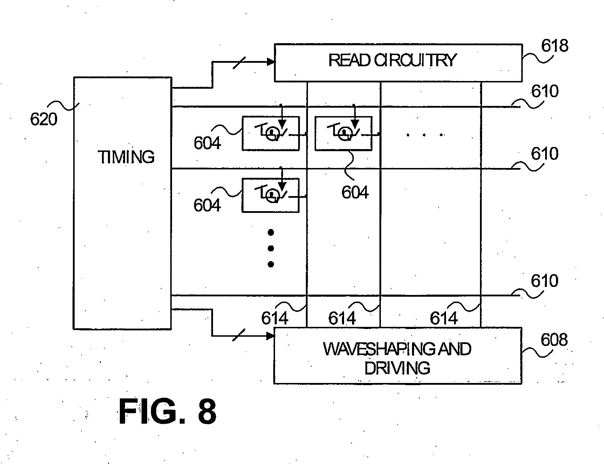

Turning now to Fig. 8, what is shown is a block diagram of a phase-change material memory device, including waveshaping and driving circuitry that are designed to provide the voltage and current levels needed to program the constituent cells of the device. The device features an array of memory cells 604 where each cell 604 can be accessed by a unique pair of vertical conductors 614 and horizontal conductors 610. In this embodiment, the horizontal conductors 610 allow a control signal from timing logic 620 to be provided to each cell 604 to close or open a solid state switch therein. This solid state switch is in series with a volume of the phase-change material whose other terminal is connected to a power supply or power return node. Current is thus sourced or sunk through the phase-change material when the switch is closed. This programming current is provided through the vertical conductors 614. The sourcing or sinking of the programming current is performed by either the read circuitry 618 or waveshaping and driving circuitry 608, depending upon whether a write or read operation is being performed. The read circuitry 618 may be entirely conventional.

The waveshaping and driving circuitry 608 will be designed so as to provide the voltage and current levels that are needed to program the cells 604 according to the first and second pulses described above, wherein the second pulse has a generally triangular shape. The waveshaping circuitry can be implemented using conventional analog waveshaping circuits such as integrator/ramp circuits, exponential and logarithmic circuits, as well as others. The shaped pulses are then driven by conventional fanout circuitry so that each cell 604 that is connected to a vertical conductor 614 is assured of receiving the desired levels of current and voltage to achieve the set sweep.

The timing associated with the generation of the pulses may be determined by timing logic 620. Timing logic 620 provides digital control signals to the waveshaping and driving circuitry 608 and the read circuitry 618 so that the latter circuits either measure the resistance of the memory cell 604 (read operation) or provide the reset and set pulses at the correct timing and to the selected memory cell 604. Accesses to the cell 604 may be in random fashion where each cell can be accessed individually, or it may be orchestrated according to a row by row basis, depending upon the higher level requirements of the memory system.

The memory device depicted in Fig. 8 may be built using a wide range of different fabrication processes, including a slightly modified version of a conventional complimentary metal oxide semiconductor (CMOS) logic fabrication process. The array of cells 604 and the waveshaping and driving circuitry 608 may be formed in the same integrated circuit (IC) die if doing so can take advantage of the lower cost of system integration on a single chip.

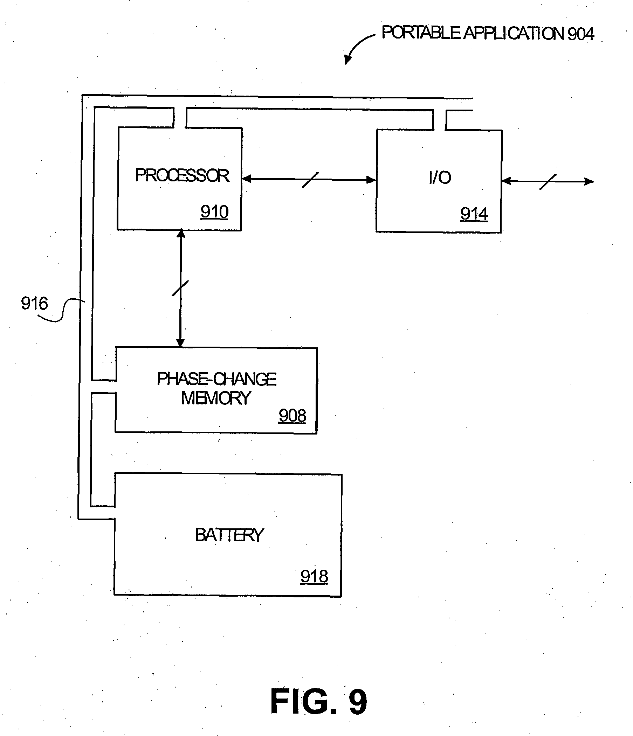

Fig. 9 illustrates a block diagram of a portable application 904 of the phase-change memory programming process described above. A phase-change memory 908 is operated according to an embodiment of the programming process described above. The phase-change memory 908 may include one or more integrated circuit dies where each die has a memory array that is programmed according to the various embodiments of the programming techniques described above in Figs. 1-8. These IC dies may be separate, stand alone memory devices that are arranged in modules such as conventional dynamic random access memory (DRAM) modules, or they may be integrated with other on-chip functionalities. In the latter embodiments, the phase-change memory 908 may be part of an I/O processor or a microcontroller.

The application 904 may be for instance a portable notebook computer, a digital still and/or video camera, a personal digital assistant, or a mobile (cellular) hand-held telephone unit. In all of these applications, an electronic system includes a processor 910 that uses the phase-change memory 908 as program memory to store code and data for its execution. Alternatively, the phase-change memory 908 may be used as a mass storage device for non-volatile storage of code and data. The portable application 904 communicates with other devices, such as a personal computer or a network of computers via an I/O interface 914. This I/O interface 914 may provide access to a computer peripheral bus, a high speed digital communication transmission line, or an antenna for unguided transmissions. Communications between the processor and the phase-change memory 908 and between the processor and the I/O interface 914 may be accomplished using conventional computer bus architectures.

The above-described components of the portable application 904 are powered by a battery 918 via a power supply bus 916. Since the application 904 is normally battery powered, its functional components including the phase-change memory 908 should be designed to provide the desired performance at low power consumption levels. In addition, due to the restricted size of portable applications, the various components shown in Fig. 9 including the phase-change memory 908 should provide a relatively high density of functionality. Of course, there are other non-portable applications for the phase-change memory 908 that are not shown. These include, for instance, large network servers or other computing devices which may benefit from a non-volatile memory device such as the phase-change memory.

As an example, the phase-change material may be Ge2Sb2Te5. An exemplary pulse may have a peak current magnitude of Ireset, where Ireset is sufficiently high to allow the cells of the array to be programmed into the reset state. The exemplary pulse may also have a falling edge that decreases from Ireset to zero current in about 200 nsec. These specifics, however, are merely exemplary and the programming technique may work with a wide range of different phase-change materials and pulse shapes having relatively slow falling edges.

To summarize, various embodiment of a phase-change material memory programming technique, referred to as a set sweep, have been described. In the foregoing specification, the invention has been described with reference to specific exemplary embodiments thereof. It will, however, be evident that various modifications and changes may be made thereto without departing from the scope of the invention as set forth in the appended claims. For instance, the phase-change material may be a chalcogenide alloy or other suitable structural phase-change material that acts as a programmable resistor. The specification and drawings are, accordingly, to be regarded in an illustrative rather than a restrictive sense.

## Claims

1. A method for programming a memory device having an array of memory cells and waveshaping and driving circuitry formed in the same integrated circuit (IC) die and configured to generate a first current pulse (204) and a second current pulse (208; 308), said method comprising:
applying the first current pulse (204) to a constituent cell (604) of the memory device, the cell (604) having a structural phase-change material to store the cell's data, to leave the material in a first state,
applying the second current pulse (208; 308) to the cell (604) to change the material from the first state to a second, different state whose resistance is lower than the resistance of the first state, the second current pulse (208; 308) having a generally triangular shape with a leading portion that peaks at a maximum value and a trailing portion that decays to a minimum value, wherein the maximum value of the second current pulse (208; 308) is high enough to cause the phase-change material in at least some of the constituent cells (604) of the device to reach an amorphizing temperature if the second current pulse (208; 308) were applied to those cells (604), and a decay rate of the second current pulse (208; 308) is slow enough to cause those constituent cells (604) that have reached the amorphizing temperature to cool down at a sufficiently slow pace so that the phase-change material in those cells (604) changes from the first state to the second state.

2. The method of claim 1 wherein the leading portion has a steeper slope than the trailing portion.

3. The method of claim 2 wherein the second current pulse (208; 308) further includes a relatively short intermediate portion between the leading portion and the trailing portion and wherein the intermediate portion has essentially zero slope relative to the leading and trailing portions.

4. A memory device comprising:
an array having a plurality of constituent cells (604), each cell (604) having a structural phase-change material to store the cell's data; and
waveshaping and driving circuitry (608) coupled to provide the voltage and current levels needed to program the plurality of constituent cells (604), the circuitry to generate a first current pulse (204) to be applied to one of the plurality of constituent cells (604) of the memory device to leave the material of said constituent cell (604) in a first state, and then a second current pulse (208; 308) to be applied to said constituent cell (604) to change its material from the first state to a second, different state whose resistance is lower than the resistance of the first state, wherein the second current pulse is to have a generally triangular shape with a leading portion that peaks at a maximum value and a trailing portion that decays to a minimum value, wherein the circuitry shapes the second current pulse (208; 308) with the maximum value high enough to cause the phase-change material in at least some of the constituent cells (604) of the device to reach an amorphizing temperature, if the second current pulse (208; 308) were applied to those cells (604), and with a decay rate low enough to cause those constituent cells (604) that have reached the amorphizing temperature to cool down at a sufficiently slow pace so that the phase-change material in those cells (604) changes from the first state to the second state, wherein the array and the waveshaping and driving circuitry (608) are formed in the same integrated circuit (IC) die.

## Patentansprüche

1. Verfahren zum Programmieren einer Speichervorrichtung mit einer Matrix von Speicherzellen und Wellenformungs- und Ansteuerungs-Schaltung, gebildet in demselben integrierten Schaltungschip (IC-Chip) und dazu ausgelegt, einen ersten Stromimpuls (204) und einen zweiten Stromimpuls (208; 308) zu erzeugen, das Verfahren umfassend:
Anlegen des ersten Stromimpulses (204) an eine Bestandteilzelle (604) der Speichervorrichtung, wobei die Zelle (604) ein strukturelles Phasenübergangsmaterial zur Speicherung der Daten der Zelle hat, um das Material in einem ersten Zustand zu lassen,
Anlegen des zweiten Stromimpulses (208; 308) an die Zelle (604), zum Übergehen des Materials von dem ersten Zustand in einen zweiten, unterschiedlichen Zustand, dessen Widerstand geringer als der Widerstand des ersten Zustands ist, wobei der zweite Stromimpuls (208; 308) eine im Wesentlichen dreieckige Form hat, mit einem vorderen Abschnitt mit Spitze bei einem Maximalwert und einem hinteren Abschnitt, der auf einen Minimalwert abfällt, wobei der Maximalwert des zweiten Stromimpulses (208; 308) groß genug ist, um das Phasenübergangsmaterial in wenigstens einigen der Bestandteilzellen (604) der Vorrichtung dazu veranlasst, eine Amorphisierungstemperatur zu erreichen, wenn der zweite Stromimpuls (208; 308) an diese Zellen (604) angelegt würde, und eine Abfallrate des zweiten Stromimpulses (208; 308) langsam genug ist, um diese Bestandteilzellen (604), die die Amorphisierungstemperatur erreicht haben, dazu zu veranlassen, hinreichend langsam abzukühlen, so dass das Phasenübergangsmaterial in diesen Zellen (604) von dem ersten Zustand in den zweiten Zustand übergeht.

2. Verfahren gemäß Anspruch 1, wobei der vordere Abschnitt eine steilere Steigung als der hintere Abschnitt hat.

3. Verfahren gemäß Anspruch 2, wobei der zweite Stromimpuls (208; 308) ferner einen relativ kurzen Zwischenabschnitt zwischen dem vorderen Abschnitt und dem hinteren Abschnitt umfasst und wobei der Zwischenabschnitt eine Steigung im Wesentlichen von Null, im Vergleich zu den vorderen und hinteren Abschnitten hat.

4. Speichervorrichtung umfassend:
eine Matrix mit mehreren Bestandteilzellen (604), wobei jede Zelle (604) ein strukturelles Phasenübergangsmaterial zur Speicherung der Daten der Zelle hat; und
Wellenformungs- und Ansteuerungs-Schaltung (608), verbunden zur Bereitstellung von Spannungs- und Strom-Niveaus, die zum Programmieren der mehreren Bestandteilzellen (604) benötigt werden, die Schaltung zum Erzeugen eines ersten Stromimpulses (204) zum Anlegen an eine der mehreren Bestandteilzellen (604) der Speichervorrichtung, um das Material der Bestandteilzelle (604) in einem ersten Zustand zu lassen, und dann eines zweiten Stromimpulses (208; 308) zum Anlegen an die Bestandteilzelle (604), um ihr Material von dem ersten Zustand in einen zweiten unterschiedlichen Zustand zu übergehen, dessen Widerstand geringer als der Widerstand des ersten Zustands ist, wobei der zweite Stromimpuls eine im Wesentlichen dreieckige Form zu haben hat mit einem vorderen Teil mit Spitze bei einem Maximalwert und einem hinteren Teil, der auf einen Minimalwert abfällt, wobei die Schaltung den zweiten Stromimpuls (208; 308) formt, mit dem Maximalwert groß genug, um das Phasenübergangsmaterial in wenigstens einigen der Bestandteilzellen (604) der Vorrichtung dazu zu veranlassen, eine Amorphisierungstemperatur zu erreichen, wenn der zweite Stromimpuls (208; 308) an diese Zellen (604) angelegt würde, und mit einer Abfallrate niedrig genug, um diese Bestandteilzellen (604), die die Amorphisierungstemperatur erreicht haben, dazu zu veranlassen, hinreichend langsam abzukühlen, so dass das Phasenübergangsmaterial in diesen Zellen (604) von dem ersten Zustand in den zweiten Zustand übergeht, wobei die Matrix und die Wellenformungs- und Ansteuerungsschaltung (608) in demselben integrierten Schaltungschip (IC-Chip) gebildet sind.

## Revendications

1. Procédé pour programmer un dispositif de mémoire comportant un réseau de cellules de mémoire et des éléments de circuit de mise en forme d'onde et de commande formés dans la même puce de circuit intégré (IC) et configurés pour générer une première impulsion de courant (204) et une deuxième impulsion de courant (208 ; 308), ledit procédé comprenant :
l'application de la première impulsion de courant (204) à une cellule constitutive (604) du dispositif de mémoire, la cellule (604) ayant un matériau structurel à changement de phase pour mémoriser les données de la cellule, pour laisser le matériau dans un premier état,
l'application de la deuxième impulsion de courant (208 ; 308) à la cellule (604) pour faire passer le matériau du premier état à un deuxième état différent dont la résistance est inférieure à la résistance du premier état, la deuxième impulsion de courant (208 ; 308) ayant une forme généralement triangulaire avec une partie de tête qui s'élève à une valeur maximum et une partie de queue qui décroît à une valeur minimum, dans lequel la valeur maximum de la deuxième impulsion de courant (208 ; 308) est suffisamment élevée pour faire en sorte que le matériau à changement de phase dans au moins certaines des cellules constitutives (604) du dispositif atteigne une température d'amorphisation si la deuxième impulsion de courant (208 ; 308) était appliquée à ces cellules (604), et la vitesse de décroissance de la deuxième impulsion de courant (208 ; 308) est suffisamment faible pour faire en sorte que ces cellules constitutives (604) qui ont atteint la température d'amorphisation se refroidissent à un rythme suffisamment lent pour que le matériau à changement de phase dans ces cellules (604) passe du premier état au deuxième état.

2. Procédé selon la revendication 1, dans lequel la partie de tête a une pente plus raide que la partie de queue.

3. Procédé selon la revendication 2, dans lequel la deuxième impulsion de courant (208 ; 308) comprend en outre une partie intermédiaire relativement courte entre la partie de tête et la partie de queue, et dans lequel la partie intermédiaire a une pente essentiellement nulle par rapport aux parties de tête et de queue.

4. Dispositif de mémoire comprenant :
un réseau comportant une pluralité de cellules constitutives (604), chaque cellule (604) ayant un matériau structurel à changement de phase pour mémoriser les données de la cellule ; et
des éléments de circuit de mise en forme d'onde et de commande (608) couplés pour fournir les niveaux de tension et de courant nécessaires pour programmer la pluralité de cellules constitutives (604), les éléments de circuit servant à générer une première impulsion de courant (204) à appliquer à l'une de la pluralité de cellules constitutives (604) du dispositif de mémoire pour laisser le matériau de ladite cellule constitutive (604) dans un premier état, et ensuite une deuxième impulsion de courant (208 ; 308) à appliquer à ladite cellule constitutive (604) pour faire passer son matériau du premier état à un deuxième état différent dont la résistance est inférieure à la résistance du premier état, dans lequel la deuxième impulsion de courant doit avoir une forme généralement triangulaire avec une partie de tête qui s'élève à une valeur maximum et une partie de queue qui décroît jusqu'à une valeur minimum, dans lequel les éléments de circuit forment la deuxième impulsion de courant (208 ; 308) avec la valeur maximum suffisamment élevée pour faire en sorte que le matériau à changement de phase dans au moins certaines des cellules constitutives (604) du dispositif atteigne une température d'amorphisation, si la deuxième impulsion de courant (208 ; 308) était appliquée à ces cellules (604), et avec une vitesse de décroissance suffisamment faible pour faire en sorte que ces cellules constitutives (604) qui ont atteint la température d'amorphisation se refroidissent à un rythme suffisamment lent pour que le matériau à changement de phase dans ces cellules (604) passe du premier état au deuxième état, dans lequel le réseau et les éléments de circuit de mise en forme d'onde et de commande (608) sont formés dans la même puce de circuit intégré (IC).
